# EUROPEAN PATENT APPLICATION

(11) **EP 4 092 910 A1**
(43) Date of publication of application: **23.11.2022**
(21) Application number: 20899387.3
(22) Date of filing: 06.05.2020
(51) Int. Cl.: H03H 9/02

(54) **BULK ACOUSTIC WAVE RESONATOR HAVING GAP LAYER ON ELECTRODE AND MANUFACTURING METHOD THEREFOR, FILTER, AND ELECTRONIC DEVICE**

(30) Priority: 09.12.2019 CN 201911248447
(71) Applicant: Rofs Microsystem (Tianjin) Co., Ltd, Tianjin 300462 (CN)
(72) Inventor: XU, Yang, Tianjin 300462 (CN); PANG, Wei, Tianjin 300072 (CN); BAN, Shengguang, Tianjin 300462 (CN); KONG, Qinglu, Tianjin 300462 (CN)
(74) Representative: Bandpay & Greuter
(86) International application number: PCT/CN2020/088702
(87) International publication number: WO 2021/114556

(57) **Abstract**

The present disclosure relates to a bulk acoustic wave resonator and a manufacturing method therefor. The resonator includes: a substrate; a bottom electrode; a top electrode; and a piezoelectric layer provided between the bottom electrode and the top electrode, wherein the bottom electrode is a gap electrode; the gap electrode has a gap layer; there is a distance between the gap layer and the top surface of the gap electrode and between the gap layer and the bottom surface of the gap electrode in the thickness direction of the gap electrode; the gap layer forms an acoustic mirror cavity of the resonator, or an acoustic mirror structure is provided in the gap layer; the substrate is provided with at least one electric connection through hole; the through hole has one end connected to the bottom electrode, and the other end suitable for being connected to a bonding pad located on the lower side of the substrate. The present disclosure further relates to a filter having the resonator and an electronic device having the filter or the resonator.

## Description

### TECHNICAL FIELD

Embodiments of the disclosure relate to the field of semiconductors, and in particular, to a bulk acoustic wave resonator and manufacturing method thereof, a filter having the resonator, and an electronic device having the resonator or the filter.

### BACKGROUND

As basic elements of an electronic apparatus, electronic devices have been widely applied, and their applications cover mobile phones, automobiles, home appliances and the like. In addition, technologies such as artificial intelligence, Internet of Things and 5G communication that will change the world in the future still need and rely on the electronic devices.

As an important member of the piezoelectric devices, a Film Bulk Acoustic Resonator (FBAR, also referred to as a bulk acoustic wave resonator (BAW)) is very important in the field of communication, and especially, an FBAR filter has gained a growing market share in the field of radio frequency filters. The traditional surface acoustic wave (SAW) filters and ceramic filters are gradually replaced by the FBAR filters due to their small dimension, high resonant frequency, high quality factor, large power capacity, good roll-off effect, and other excellent characteristics. Such the FBAR filters are used widely in the field of wireless communication radio frequency, and can be also applicable to the sensing filed such as biology, physics, and medicine due to their high sensitivity.

The film bulk acoustic resonator mainly includes a "sandwich" structure composed of electrode-piezoelectric film-electrode, i.e., the piezoelectric material is sandwiched between the two metal electrodes. When a sinusoidal signal is input between the two electrodes, the FBAR converts an input electrical signal into a mechanical resonance through an inverse piezoelectric effect, and then converts the mechanical resonance into an electrical signal output by the piezoelectric effect.

The rapid development of communication technologies requires a continuous increase in the working frequency of a filter. For example, the frequency of a 5G communication frequency band (sub-6G) is between 3 GHz and 6 GHz, which is higher than that of 4G and other communication technologies. As for the bulk acoustic wave resonator and the filter, the high working frequency means that the film thickness, especially the film thickness of an electrode, needs to be further reduced. However, a main negative effect caused by the decrease in the film thickness of the electrode is a decrease in a Q value of the resonator resulting from an increase in the electrical loss, especially a decrease in the Q value at a series resonance point and its nearby frequencies. Correspondingly, the performance of a bulk acoustic wave filter with a high working frequency is greatly deteriorated with the decrease in the Q value of the bulk acoustic wave resonator.

In addition, there are requirements to improve power capacity of the filter and to reduce a dimension of a filter.

### SUMMARY

In order to alleviate or solve above problems in the related art, or to improve power capacity or reduce a filter dimension, the present disclosure is provided.

According to an aspect of embodiments of the present disclosure, there is provided a bulk acoustic wave resonator, which includes a substrate, a bottom electrode, a top electrode, and a piezoelectric layer provided between the bottom electrode and the top electrode. The bottom electrode is a gap electrode, and the gap electrode is provided with a gap layer. The gap layer is spaced apart from each of a top surface and a bottom surface of the gap electrode in a thickness direction of the gap electrode. The gap layer forms an acoustic mirror cavity of the resonator or an acoustic mirror structure is provided in the gap layer. The substrate is provided with at least one electrical connection through hole, the at least one electrical connection through hole has one end connected to the bottom electrode and another end connected to a bondpad, and the bondpad is located on a lower side of the substrate.

An embodiment of the present disclosure also relates to a filter including the bulk acoustic wave resonator as described above.

An embodiment of the present disclosure also relates to a method of manufacturing a bulk acoustic wave resonator. The method includes: providing a substrate and depositing a first bottom electrode layer on an upper side of the substrate; forming a patterned sacrificial layer on the first bottom electrode layer; depositing a second bottom electrode layer in such a manner that the second bottom electrode layer covers the sacrificial layer and the first bottom electrode layer, the first bottom electrode layer and the second bottom electrode layer being electrically connected to each other; patterning the first bottom electrode layer and the second bottom electrode layer to form a bottom electrode; depositing a piezoelectric layer and a top electrode layer, and patterning the top electrode layer to form a top electrode; releasing the sacrificial layer; and etching a conductive through hole penetrating through the substrate, and forming a conductive bondpad electrically connected to the conductive through hole on a lower side of the substrate.

An embodiment of the present disclosure also relates to an electronic device including the filter or the resonator as described above, or the bulk acoustic wave resonator manufactured according to the method as described above.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1 is a schematic top view of a bulk acoustic wave resonator according to an exemplary embodiment of the present disclosure.
FIG. 1A is a schematic sectional view along line A-A in FIG. 1 according to an exemplary embodiment of the present disclosure.
FIG. 2 is a schematic sectional view along line A-A similar to that in FIG. 1 according to another exemplary embodiment of the present disclosure, in which a plurality of conductive through holes is shown.
FIG. 3 is a schematic top view of a bulk acoustic wave resonator according to an exemplary embodiment of the present disclosure.
FIG. 3A is a schematic sectional view along line A-B in FIG. 3 according to an exemplary embodiment of the present disclosure.
FIG. 4 is a schematic top view of a bulk acoustic wave resonator according to an exemplary embodiment of the present disclosure.
FIG. 4A is a schematic sectional view along line A-A in FIG. 4 according to an exemplary embodiment of the present disclosure.
FIGS. 5A to 51 are schematic diagrams of a manufacturing process of a bulk acoustic wave resonator according to an exemplary embodiment of the present disclosure.
FIG. 6A is a schematic sectional view of a bulk acoustic wave resonator according to an exemplary embodiment of the present disclosure, in which a gap seed layer is provided at an upper side of the gap layer and a barrier layer is provided at a lower side of the gap layer.
FIG. 6B is a schematic sectional view of a bulk acoustic wave resonator according to an exemplary embodiment of the present disclosure, in which a gap seed layer is provided at an upper side of the gap layer and a barrier layer is provided at a lower side of the gap layer.
FIG. 6C is a schematic sectional view of a bulk acoustic wave resonator according to an exemplary embodiment of the present disclosure, in which a gap seed layer is provided at an upper side of the gap layer and a barrier layer is provided on a lower side of the gap layer.
FIGS. 7A to 71 are schematic diagrams of a manufacturing process of a bulk acoustic wave resonator according to another exemplary embodiment of the present disclosure.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as limitation to the present disclosure.

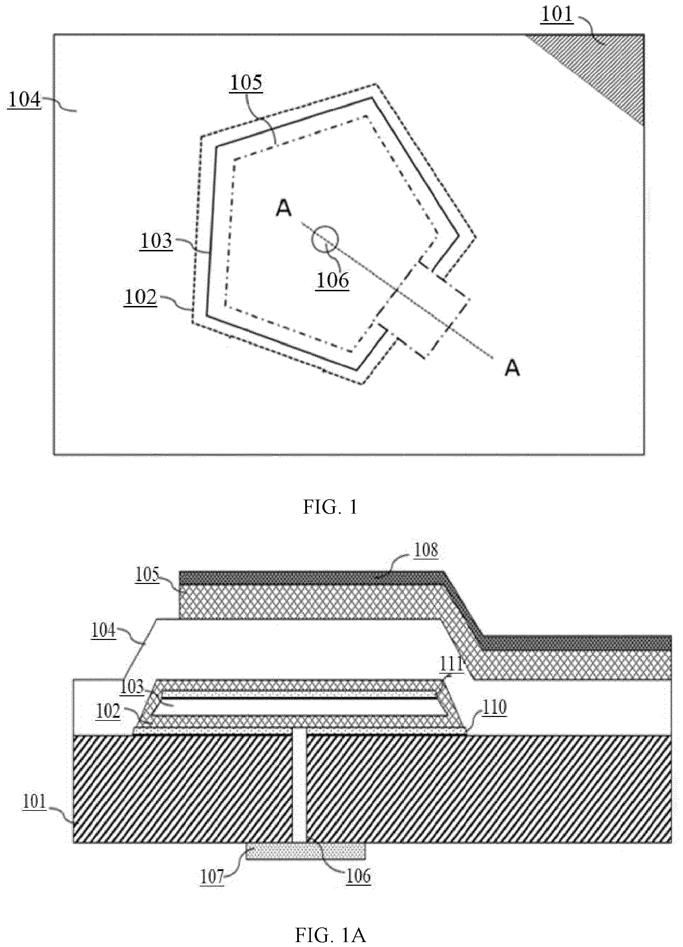

FIG. 1 is a schematic top view of a bulk acoustic wave resonator according to an exemplary embodiment of the present disclosure, and FIG. 1A is a schematic sectional view along line A-A in FIG. 1 according to an exemplary embodiment of the present disclosure. In FIG. 1 and FIG. 1A, reference numbers are as follows.

101 denotes a substrate, which can be made of a material such as monocrystalline silicon, gallium arsenide, sapphire, and quartz.

102 denotes a bottom electrode, which can be made of a material such as molybdenum, ruthenium, gold, aluminum, magnesium, tungsten, copper, titanium, iridium, osmium, chromium, or composites or alloys thereof.

103 denotes an acoustic mirror, which may be a cavity, or may adopt a Bragg reflection layer and other equivalent forms.

104 denotes a piezoelectric film layer, which can be made of a material such as aluminum nitride, zinc oxide, and PZT and contains the above materials doped with a certain atomic ratio of rare earth element.

105 denotes a top electrode, which can be made of a material such as molybdenum, ruthenium, gold, aluminum, magnesium, tungsten, copper, titanium, iridium, osmium, chromium, or composites or alloys thereof.

106 denotes a through hole etched in the substrate that may be referred to as a via, and there may be provided with a single through hole or a plurality of through holes.

107 denotes a bondpad for leading out an electrical signal, which can be configured for later packaging, and can be configured to supply power to the bottom electrode and to be a part of a bottom electrode pin.

108 denotes a passivation layer on a surface of the top electrode.

110 denotes a crystal orientation seed layer, which can be AlN.

111 denotes a crystal orientation seed layer, which can be AIN.

It should be noted that the air gap forms a gap layer. However, in the present disclosure, the gap layer may be a vacuum gap layer except for an air gap layer, or may be a gap layer filled with other gas medium. Although not shown, in alternative embodiments, the gap layer has a sufficient space such that an acoustic mirror structure, such as a Bragg reflection layer, may be disposed in the gap layer.

It should be noted that the crystal orientation seed layers 110, 111 and the passivation layer 108 of the above structure can be omitted.

In an embodiment shown in FIG. 1A, a conductive through hole 106 is provided at a geometric center of the gap layer. An expression "provided at the geometric center" herein includes a position adjacent to the geometric center, for example, within a range with a radius of 10 µm and the geometric center as a center. However, the conductive through hole 106 may be provided at other positions.

In the present disclosure, the bottom electrode contains a gap layer. Such a way of moving an acoustic reflection layer into an electrode makes the bottom electrode completely contact with the substrate. In this way, a through hole structure is etched in the substrate such that the electrical signal is directly transmitted from the bottom electrode of the resonator through the through hole. A filter product including the resonator of the present disclosure does not need to additionally add a signal lead-out structure (such as, a pad), so that a dimension of such a product can be reduced.

In the present disclosure, a thickness of the gap layer is optionally in a range of 50 Å to 10000 Å. In a further embodiment, a height of the gap layer is greater than a typical amplitude (about 10 nm) of the resonator, and correspondingly, the height of the gap layer is in a range of 100 Å to 5000 Å. This facilitates acoustic energy decoupling between the top electrode and a resonant cavity that is a composite structure composed of the top electrode, the piezoelectric layer, and the bottom electrode in this embodiment when the resonator operates at a high power.

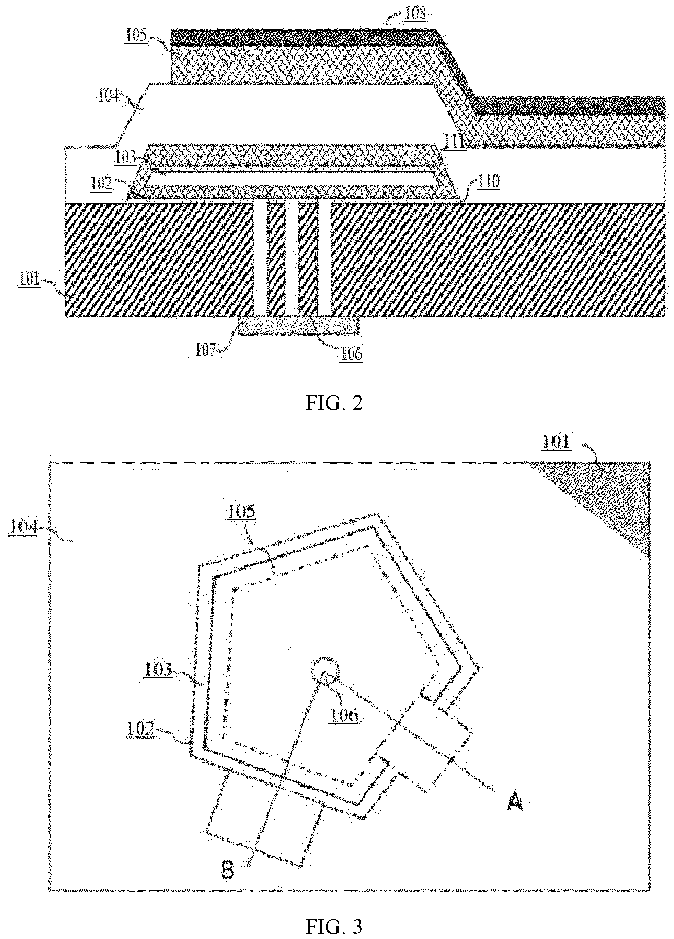

FIG. 2 is a schematic sectional view along line A-A similar to that in FIG. 1 according to another exemplary embodiment of the present disclosure, in which a plurality of conductive through holes is shown. In an embodiment of FIG. 2, a plurality of conductive through holes is electrically connected with the same conductive bondpad.

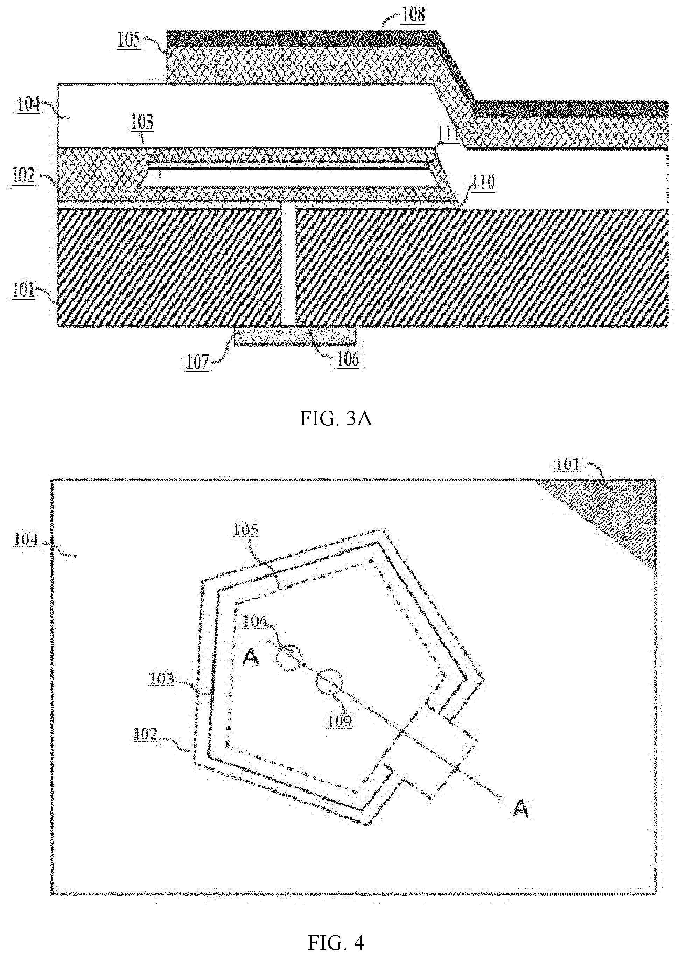

FIG. 3 is a schematic top view of a bulk acoustic wave resonator according to an exemplary embodiment of the present disclosure, and FIG. 3A is a schematic sectional view along line A-B in FIG. 3 according to an exemplary embodiment of the present disclosure.

The resonator shown in FIGS. 3 and 3A is different from the resonator shown in FIG. lAin that a bottom electrode also extends laterally to form an extension portion. As shown in FIGS. 3A and 3, the bottom electrode 104 extends beyond an effective region of the resonator. The extension portion may be connected to bottom electrodes of other resonators. In the illustrated embodiment, a conductive through hole 106 is provided at a geometric center of a gap layer. An expression "provided at the geometric center" herein includes a position adjacent to the geometric center, for example, within a range with a radius of 10 µm and the geometric center as a center. However, the conductive through hole 106 may be provided at other positions.

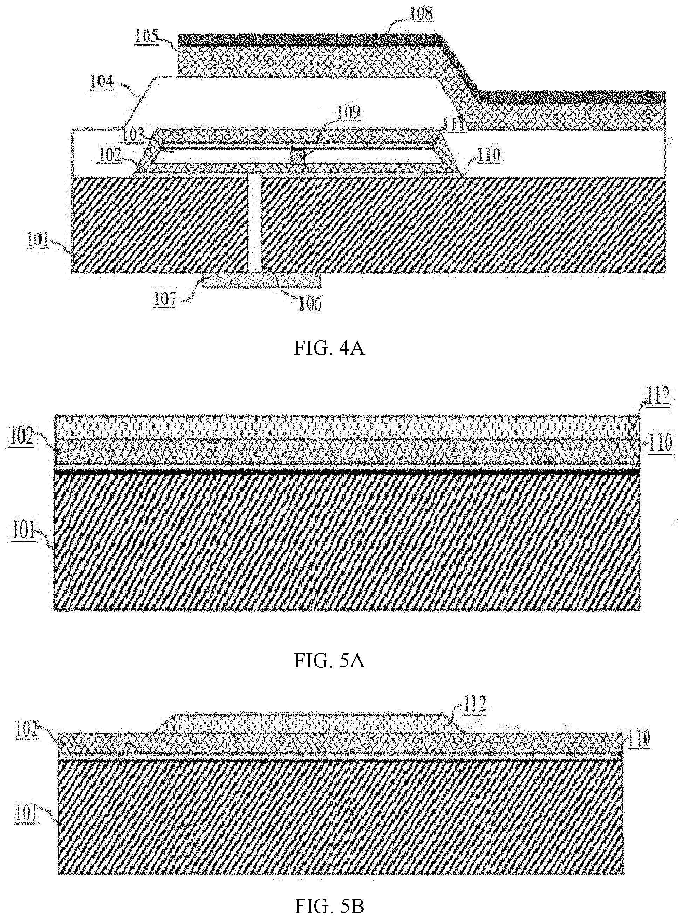

FIG. 4 is a schematic top view of a bulk acoustic wave resonator according to an exemplary embodiment of the present disclosure, and FIG. 4A is a schematic sectional view along line A-A in FIG. 4 according to an exemplary embodiment of the present disclosure.

In FIGS. 4A and 4, a pillar structure 109 is provided in the gap layer. The pillar structure may be made of the same material as the bottom electrode, or it may be made of a different material from that of the bottom electrode. As shown in FIG. 4A, the pillar structure 109 is supported and connected between an upper side and a lower side of the gap layer. On the one hand, the pillar structure can prevent upper and lower electrode layers of the gap layer from being attached to each other due to a stress and other factors. On the other hand, the pillar structure can accelerate heat conduction of the resonator to the substrate.

It should be noted that a height of the pillar structure 109 may be lower than a height of a gap in the gap layer, which can prevent the upper and lower electrode layers of the gap layer from being attached to each other due to the stress and other factors. The pillar structure can be provided at the geometric center of the gap layer. An expression "provided at the geometric center" herein includes a position adjacent to the geometric center, for example, within a range with a radius of 10 µm and with the geometric center as a center.

In an illustrated embodiment, the conductive through hole 106 and the pillar structure 109 do not overlap in a thickness direction of the resonator, but the present disclosure is not limited to this. In an alternative embodiment, the conductive through hole overlaps with the pillar structure in a projection of the resonator along the thickness direction. An expression "overlap" herein includes not only partial and entire overlapping of projections of the conductive through hole and the pillar structure, but also includes a case where a lateral distance between projection centers of the conductive through hole and the pillar structure does not exceed 10 µm. In an alternative embodiment, one conductive through hole 106 is provided at a geometric center of the gap layer. An expression "provided at the geometric center" herein includes a position adjacent to the geometric center, for example, within a range with a radius of 10 µm and with the geometric center as a center.

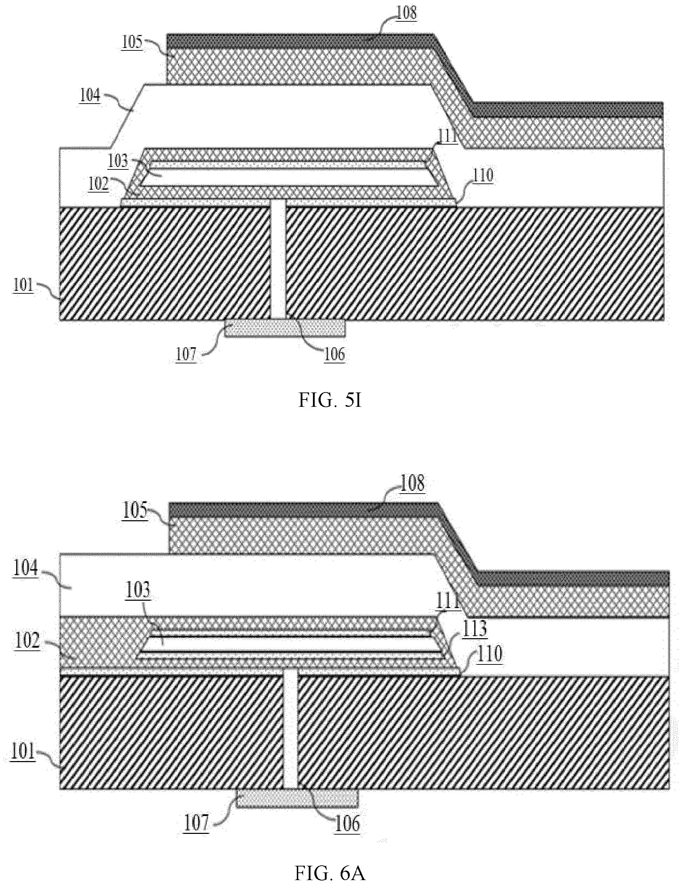

FIGS. 5A to 5I are schematic diagrams of a manufacturing process of a bulk acoustic wave resonator according to an exemplary embodiment of the present disclosure. The manufacturing process of the bulk acoustic wave resonator is exemplarily described with reference to FIGS. 5A to 5I below.

Firstly, as shown in FIG. 5A, a first seed layer 110, a first bottom electrode layer 102 and a sacrificial layer 112 are deposited on a substrate 101.

Further, as shown in FIG. 5B, the sacrificial layer 112 is patterned.

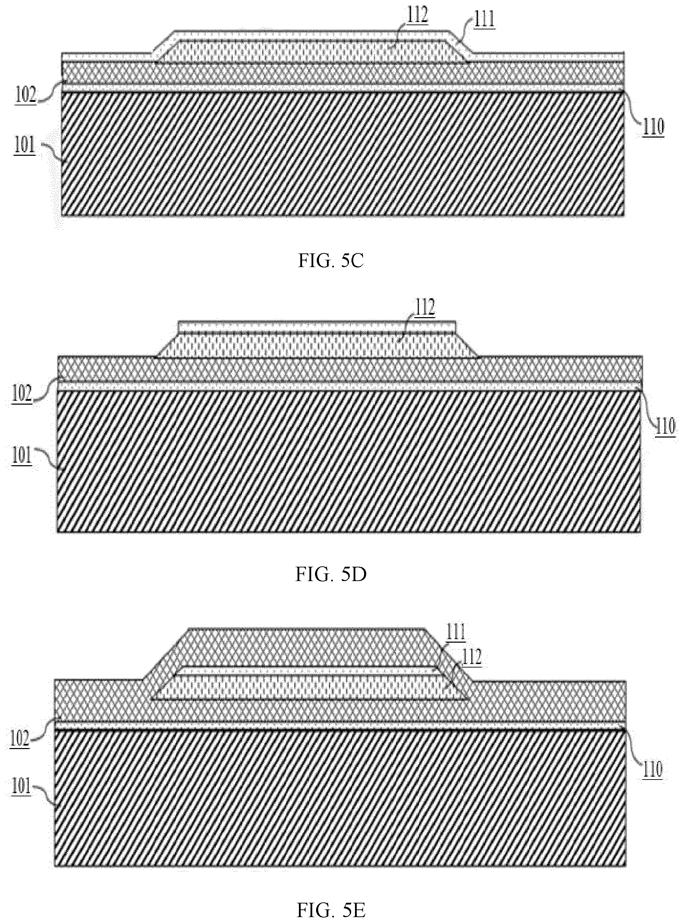

Next, as shown in FIG. 5C, a second seed layer 111 is deposited.

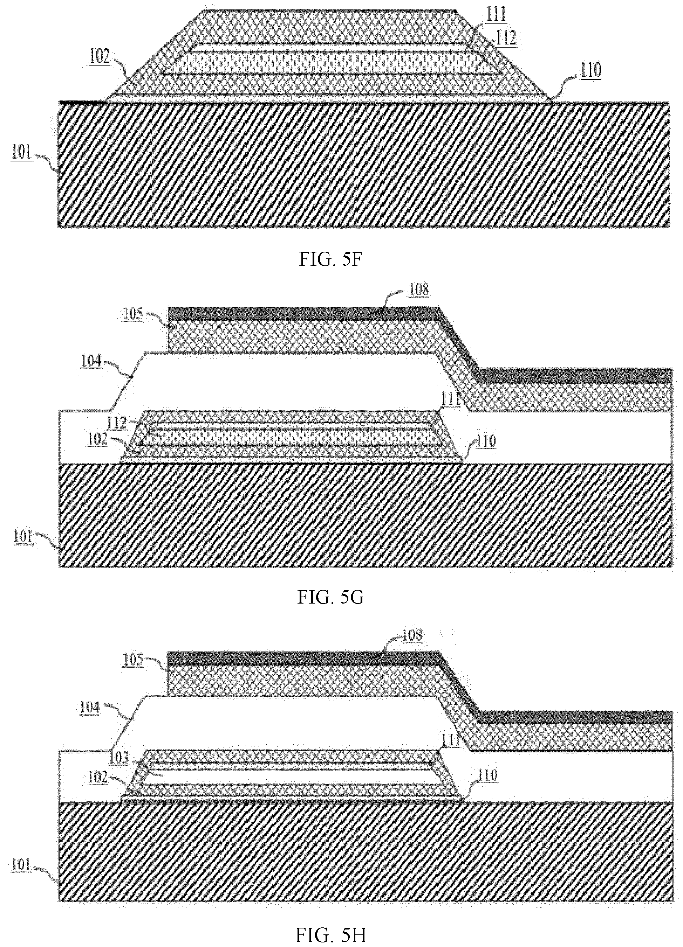

Referring to FIG. 5D, the second seed layer 111 is patterned. After that, in FIG. 5E, a second bottom electrode layer 102 is deposited. In FIG. 5F, the first bottom electrode layer and the second bottom electrode layer are patterned to form a final bottom electrode.

Referring to FIG. 5G, a piezoelectric layer 104, a top electrode 105 and a passivation layer 108 are deposited, and the top electrode is patterned.

Then, as shown in FIG. 5H, the sacrificial layer 112 is released to form a gap layer, which can be used as an acoustic mirror cavity of the resonator.

Referring to FIG. 51, a conductive through hole 106 is etched on a lower side of the substrate, and a conductive bondpad is deposited and patterned.

It should be noted that in the above method, the first seed layer and/or the second seed layer may not be provided, and the passivation layer 108 may not be provided.

In addition, the above performing sequence of the steps can be changed based on actual situations. For example, the release of the sacrificial layer 112 can be performed after etching the through hole and forming the conductive bondpad. For example, after the first seed layer is formed (if any), or in a case where there has no the first seed layer, the conductive through hole 106 and the conductive bondpad 107 is provided firstly, and the first bottom electrode layer is then deposited. All of the above are within the scope of the present disclosure.

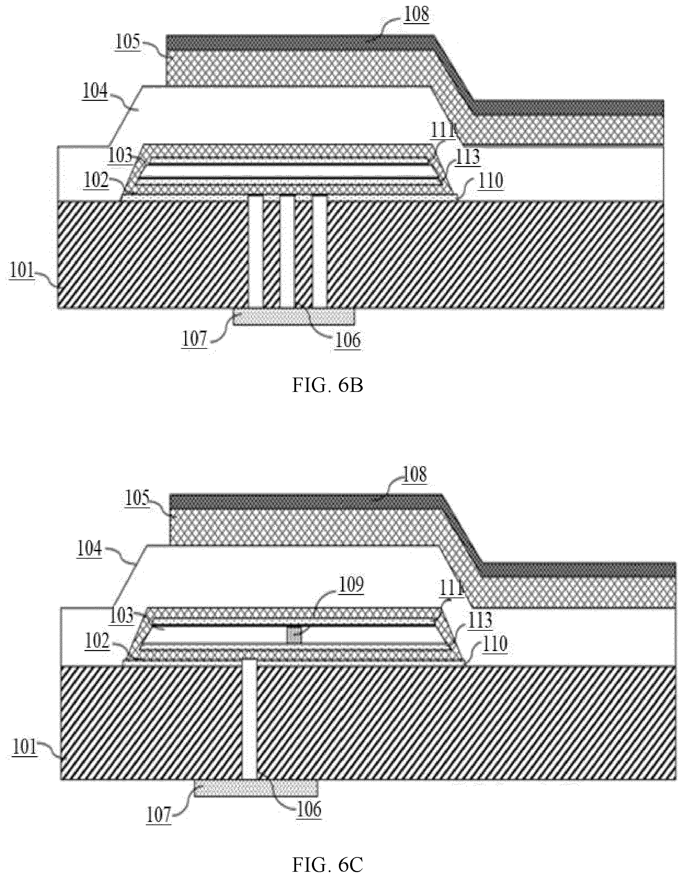

FIG. 6A is a schematic sectional view of a bulk acoustic wave resonator according to an exemplary embodiment of the present disclosure, in which a gap seed layer is provided on an upper side of a gap layer and a barrier layer is provided on a lower side of the gap layer, and one through hole is shown. FIG. 6B is a schematic sectional view of a bulk acoustic wave resonator according to an exemplary embodiment of the present disclosure, in which a gap seed layer is provided on an upper side of a gap layer and a barrier layer is provided on a lower side of the gap layer, and three through holes are shown. FIG. 6C is a schematic sectional view of a bulk acoustic wave resonator according to an exemplary embodiment of the present disclosure, in which a gap seed layer is provided on an upper side of a gap layer, a barrier layer is provided on a lower side of the gap layer, and a pillar structure is shown.

FIGS. 6A to 6C are similar to FIGS. 3A, 2 and 4A, respectively, except that the gap seed layer 111 and the barrier layer 113 are provided in FIGS. 6A to 6C, while only the gap seed layer 111 is provided in FIGS. 3A, 2 and 4A.

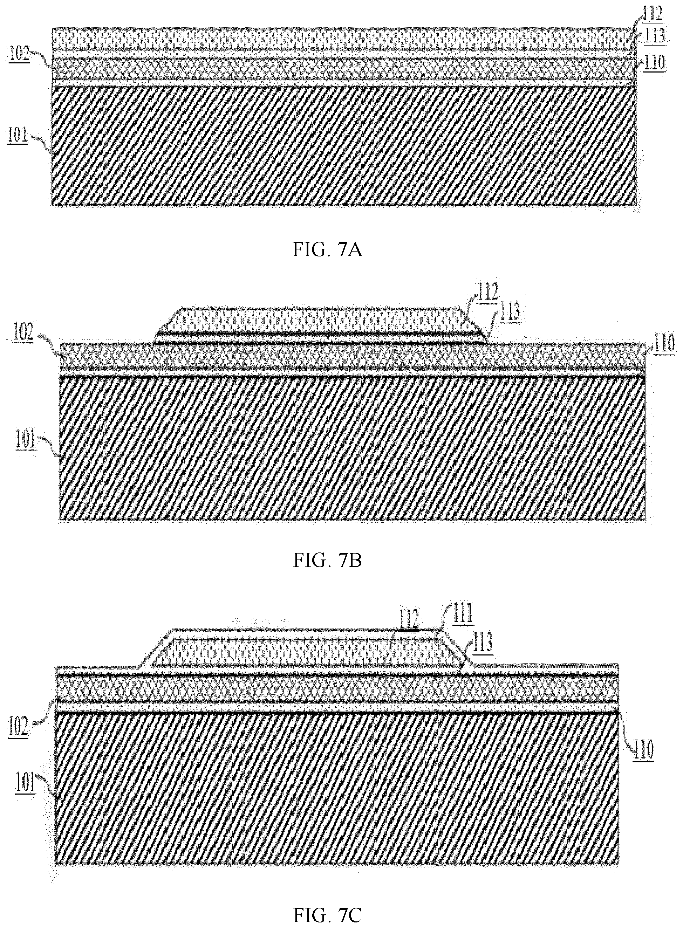

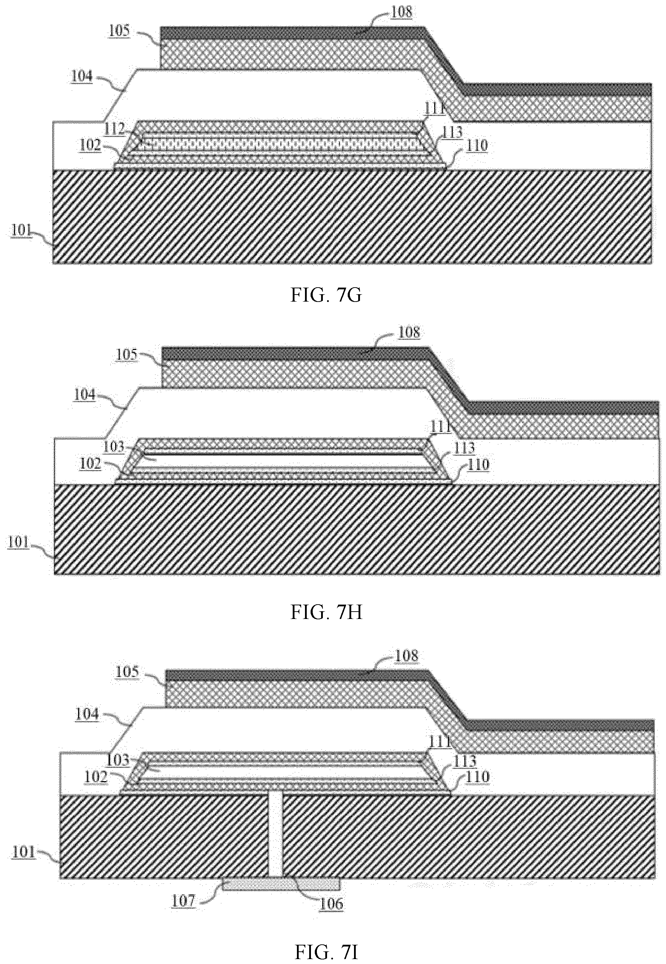

FIGS. 7A to 7I are schematic diagrams of a manufacturing process of a bulk acoustic wave resonator according to another exemplary embodiment of the present disclosure. The manufacturing process of the bulk acoustic wave resonator is exemplarily described with reference to FIGS. 7A to 7I below.

Firstly, as shown in FIG. 7A, a first seed layer 110, a first bottom electrode layer 102, a barrier layer 113 and a sacrificial layer 112 are deposited on a substrate 101.

Further, as shown in FIG. 7B, the sacrificial layer 112 and the barrier layer 113 are patterned.

Next, as shown in FIG. 7C, a gap seed layer 111 is deposited.

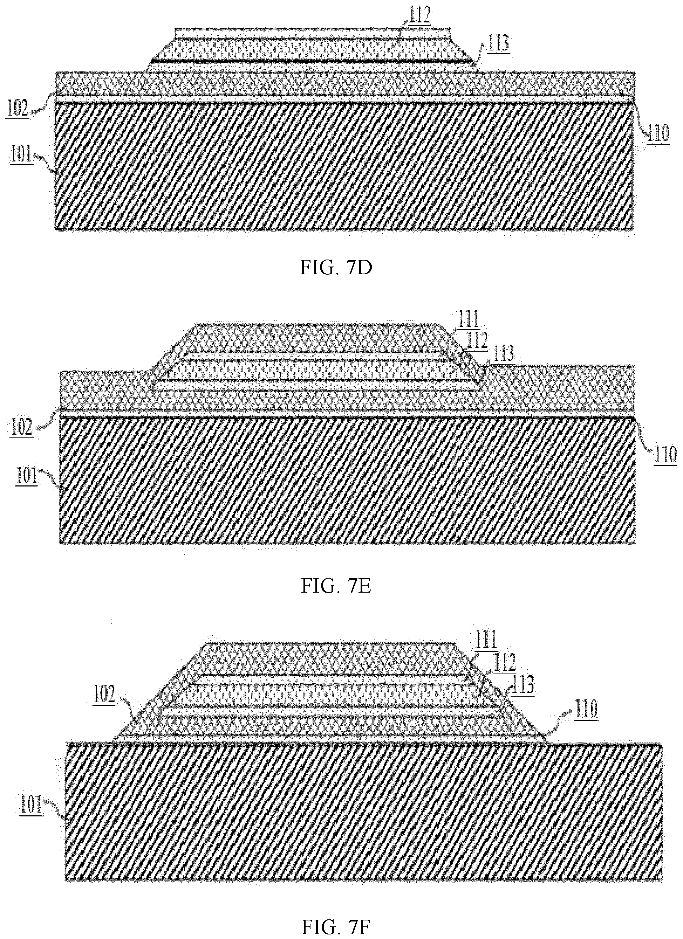

As shown in FIG. 7D, the gap seed layer 111 is patterned.

As shown in FIG. 7E, a second bottom electrode layer 102 is then deposited.

In FIG. 7F, the first bottom electrode layer, the second bottom electrode layer and the first seed layer 110 are patterned to form a final bottom electrode.

Referring to FIG. 7G, a piezoelectric layer 104, a top electrode 105 and a passivation layer 108 are deposited, and the top electrode is patterned.

After that, as shown in FIG. 7H, the sacrificial layer 112 is released to form a gap layer 103, which can be used as an acoustic mirror cavity of the resonator.

Referring to FIG. 71, a conductive through hole 106 is etched on a lower side of the substrate, and a conductive bondpad 107 is deposited and patterned.

In addition, the above performing sequence of the steps can be changed based on actual situations. For example, the release of the sacrificial layer 112 can be performed after etching the through hole and forming the conductive bondpad. For example, the conductive through hole 106 and the conductive bondpad 107 may be provided firstly, and then the first bottom electrode layer may be deposited. All of the above are within the scope of the present disclosure.

In the manufacturing method of the bulk acoustic wave resonator of the present disclosure, the gap layer of the bottom electrode is used as the acoustic mirror, thereby eliminating a chemical mechanical polishing (CMP) process of forming an acoustic mirror cavity in the substrate.

In addition, in the present disclosure, the through hole 106 provided in the substrate is directly electrically connected to the bottom electrode without an additional metal connection structure, such that a smaller signal transmission loss and a smaller electrical connection resistance can be obtained.

In a case of providing the pillar structure 109, the above method of the present disclosure may include following steps. A pillar structure is formed on an upper side of the substrate before forming a patterned sacrificial layer on a first bottom electrode layer. In the forming the patterned sacrificial layer on the first bottom electrode layer, a height of the pillar structure is not greater than a thickness of the sacrificial layer. As compared with the CMP process, the film deposition method for forming the pillar structure 109 as described above has excellent on-chip uniformity, and a deposition rate does not change with the pattern density. Accordingly, it is unnecessary to deliberately increase a thickness of the gap layer to accommodate errors of the CMP process. Since a pillar structure with an excessively large width can degrade resonator performance, on a premise of not increasing a width of the pillar structure as possible, a pillar structure with a relatively large aspect ratio, that is, a firmer pillar structure, can be obtained with the structure of the present disclosure. In addition, the above method can effectively control the height of the pillar structure 109, and easily achieve a fixed connection between the pillar structure 109 and the upper and lower sides.

It should be noted that the provision of the pillar structure does not have to be performed before or after the forming of the sacrificial layer. For example, after the sacrificial layer is deposited, a small hole can be formed in the middle of the sacrificial layer when the sacrificial layer is being patterned. After that, when the second bottom electrode such as Mo metal is being deposited, a small pillar may be formed of Mo metal in the small hole, that is, the pillar structure.

In the present disclosure, when a gap layer is provided in the bottom electrode, the effective region of the resonator is an overlapping region of the top electrode, the bottom electrode, the piezoelectric layer, and the gap layer of the bottom electrode in the thickness direction of the resonator.

A numerical range mentioned in the present disclosure encompass not only end values, but also a median value or other values between the end values, all of which are within a protection scope of the present disclosure.

According to the disclosure, a signal lead-out structure is not required to be additionally added, but the signal is directly led out from a lower part of the resonator, so that the dimension of the resonator can be reduced, and a dimension of the air cavity as the acoustic mirror is thinned to further reduce the dimension.

In the present disclosure, there is no need to add additional signal lead-out structures. The signals can be directly transmitted from a lower portion of the resonator to reduce the dimension of the resonator, and the thinning of the air cavity as the acoustic mirror can further reduce the dimension of the resonator.

In the present disclosure, the bottom electrode is directly arranged on the substrate to facilitate heat transmission. Meanwhile, the air cavity is thinned, and heat of a resonator body is easily radiated to the bottom electrode. The pillar structure is provided such that heat conduction performance can be improved. These facilitate improving of heat dissipation and meet demand for increased power of devices.

As can be understood by those skilled in the art, the bulk acoustic wave resonator according to the present disclosure can be configured to form a filter.

In view of the above, the present disclosure provides following technical solutions.
1. A bulk acoustic wave resonator includes:
   a substrate;
   a bottom electrode;
   a top electrode; and
   a piezoelectric layer provided between the bottom electrode and the top electrode,
   wherein
   the bottom electrode is a gap electrode, the gap electrode is provided with a gap layer, the gap layer is spaced apart from each of a top surface and a bottom surface of the gap electrode in a thickness direction of the gap electrode, and the gap layer forms an acoustic mirror cavity of the resonator or an acoustic mirror structure is formed in the gap layer; and
   the substrate is provided with at least one electrical connection through hole, the at least one electrical connection through hole has one end connected to the bottom electrode and another end connected to a bondpad, and the bondpad is located on a lower side of the substrate.
2. The resonator according to 1, wherein
   the gap layer is an air gap layer or a vacuum gap layer.
3. The resonator according to 1, wherein
   the gap layer has a thickness in a range of 50 Å to 10000 Å.
4. The resonator according to 3, wherein
   the gap layer has a thickness in a range of 100 Å to 5000 Å.
5. The resonator according to 1, wherein
   the bottom electrode is entirely located on an upper surface of the substrate.
6. The resonator according to 1, wherein
   at least one of the at least one electrical connection through holes is arranged below the bottom electrode, and is directly connected to the bottom electrode in a thickness direction of the resonator; or
   in a projection of the resonator in the thickness direction of the resonator, at least one of the at least one electrical connection through holes is located in an effective region of the resonator.
7. The resonator according to any one of 1 to 6, wherein
   a first crystal orientation seed layer is provided between the bottom electrode and the substrate, and the at least one electrical connection through hole penetrates through the first crystal orientation seed layer.
8. The resonator according to any one of 1 to 6 further includes:
   a pillar structure provided in the gap layer.
9. The resonator according to 8, wherein
   the pillar structure connects upper and lower sides of the gap layer.
10. The resonator according to 9, wherein
   the pillar structure is a heat conductive structure.
11. The resonator according to 10, wherein
   the pillar structure is arranged at a geometric center of the gap layer.
12. The resonator according to 11, wherein
   in a projection of the resonator in a thickness direction of the resonator, one of the at least one electrical connection through hole overlaps with the pillar structure.
13. The resonator according to any one of 1 to 6, wherein
   the bottom electrode has a bottom electrode extension portion that extends laterally beyond an effective region of the resonator.
14. The resonator according to any one of 1 to 6, wherein
   the gap layer is provided with a barrier layer on a lower side thereof, and the barrier layer is configured to define a boundary of the lower side of the gap layer; and/or
   the gap layer is provided with a gap seed layer on an upper side thereof, and the gap seed layer is configured to define a boundary of the upper side of the gap layer.
15. A filter includes the bulk acoustic wave resonator according to any one of 1 to 14.
16. The filter according to 15, wherein
   the filter includes two bulk acoustic wave resonators according to 13, and bottom electrodes of the two bulk acoustic wave resonators are electrically connected with each other through bottom electrode extension portions.
17. A method of manufacturing a bulk acoustic wave resonator includes:
   providing a substrate and depositing a first bottom electrode layer on an upper side of the substrate;
   forming a patterned sacrificial layer on the first bottom electrode layer;
   depositing a second bottom electrode layer in such a manner that the second bottom electrode layer covers the sacrificial layer and the first bottom electrode layer, the first bottom electrode layer and the second bottom electrode layer being electrically connected to each other;
   patterning the first bottom electrode layer and the second bottom electrode layer to form a bottom electrode;
   depositing a piezoelectric layer and a top electrode layer, and patterning the top electrode layer to form a top electrode;
   releasing the sacrificial layer; and
   etching a conductive through hole penetrating through the substrate, and forming a conductive bondpad electrically connected to the conductive through hole on a lower side of the substrate.
18. The method according to 17, wherein
   before depositing the first bottom electrode layer, the method further includes depositing and patterning a first crystal orientation seed layer on the upper side of the substrate, wherein the first bottom electrode layer is deposited in such a manner that the first bottom electrode layer covers the first crystal orientation seed layer; and
   in the etching the conductive through hole penetrating through the substrate, the conductive through hole passes through the first crystal orientation seed layer.
19. The method according to 17, wherein
   the method further includes forming a pillar structure on the upper side of the substrate; and
   in the forming the patterned sacrificial layer on the first bottom electrode layer, a height of the pillar structure is not greater than a thickness of the sacrificial layer.
20. The method according to any one of 17 to 19, wherein
   before the forming the patterned sacrificial layer on the first bottom electrode layer, the method further includes providing and patterning a barrier layer on the first bottom electrode layer, and the forming the patterned sacrificial layer on the first bottom electrode layer includes forming the patterned sacrificial layer on the barrier layer; and/or
   before the depositing the second bottom electrode layer, the method further includes providing and patterning a gap seed layer on the sacrificial layer, and the depositing the second bottom electrode layer includes depositing the second bottom electrode layer on the gap seed layer.
21. An electronic device includes the filter according to 15 or 16, the resonator according to any one of 1 to 14, or a resonator manufactured by the method according to any one of 17 to 20.

Although the embodiments of the present disclosure have been shown and described, it should be understood for those skilled in the art that modifications may be made to these embodiments without departing from the principle and spirit of the present disclosure, and the scope thereof is defined by the appended claims and their equivalent.

## Claims

1. A bulk acoustic wave resonator, comprising:
a substrate;
a bottom electrode;
a top electrode; and
a piezoelectric layer provided between the bottom electrode and the top electrode,
wherein the bottom electrode is a gap electrode, the gap electrode is provided with a gap layer, the gap layer is spaced apart from each of a top surface and a bottom surface of the gap electrode in a thickness direction of the gap electrode, and the gap layer forms an acoustic mirror cavity of the resonator or an acoustic mirror structure is formed in the gap layer; and
wherein the substrate is provided with at least one electrical connection through hole, the at least one electrical connection through hole has one end connected to the bottom electrode and another end connected to a bondpad, and the bondpad is located on a lower side of the substrate.

2. The resonator according to claim 1, wherein the gap layer is an air gap layer or a vacuum gap layer.

3. The resonator according to claim 1, wherein the gap layer has a thickness in a range of 50 Å to 10000 Å.

4. The resonator according to claim 3, wherein the gap layer has a thickness in a range of 100 Å to 5000 Å.

5. The resonator according to claim 1, wherein the bottom electrode is entirely located on an upper surface of the substrate.

6. The resonator according to claim 1, wherein at least one of the at least one electrical connection through holes is arranged below the bottom electrode, and is directly connected to the bottom electrode in a thickness direction of the resonator; or
in a projection of the resonator in a thickness direction of the resonator, at least one of the at least one electrical connection through holes is located in an effective region of the resonator.

7. The resonator according to any one of claims 1 to 6, wherein a first crystal orientation seed layer is provided between the bottom electrode and the substrate, and the at least one electrical connection through hole penetrates through the first crystal orientation seed layer.

8. The resonator according to any one of claims 1 to 6, further comprising:
a pillar structure provided in the gap layer.

9. The resonator according to claim 8, wherein the pillar structure connects upper and lower sides of the gap layer.

10. The resonator according to claim 9, wherein the pillar structure is a heat conductive structure.

11. The resonator according to claim 10, wherein the pillar structure is arranged at a geometric center of the gap layer.

12. The resonator according to claim 11, wherein in a projection of the resonator in a thickness direction of the resonator, one of the at least one electrical connection through hole overlaps with the pillar structure.

13. The resonator according to any one of claims 1 to 6, wherein the bottom electrode has a bottom electrode extension portion that extends laterally beyond an effective region of the resonator.

14. The resonator according to any one of claims 1 to 6, wherein the gap layer is provided with a barrier layer on a lower side thereof, and the barrier layer is configured to define a boundary of the lower side of the gap layer; and/or
the gap layer is provided with a gap seed layer on an upper side thereof, and the gap seed layer is configured to define a boundary of the upper side of the gap layer.

15. A filter, comprising the bulk acoustic wave resonator according to any one of claims 1 to 14.

16. The filter according to claim 15, wherein the filter includes two bulk acoustic wave resonators according to claim 13, and bottom electrodes of the two bulk acoustic wave resonators are electrically connected with each other through bottom electrode extension portions.

17. A method of manufacturing a bulk acoustic wave resonator, comprising:
providing a substrate and depositing a first bottom electrode layer on an upper side of the substrate;
forming a patterned sacrificial layer on the first bottom electrode layer;
depositing a second bottom electrode layer in such a manner that the second bottom electrode layer covers the sacrificial layer and the first bottom electrode layer, the first bottom electrode layer and the second bottom electrode layer being electrically connected to each other;
patterning the first bottom electrode layer and the second bottom electrode layer to form a bottom electrode;
depositing a piezoelectric layer and a top electrode layer, and patterning the top electrode layer to form a top electrode;
releasing the sacrificial layer; and
etching a conductive through hole penetrating through the substrate, and forming a conductive bondpad electrically connected to the conductive through hole on a lower side of the substrate.

18. The method according to claim 17, wherein before depositing the first bottom electrode layer, the method further comprises depositing a first crystal orientation seed layer on the upper side of the substrate, wherein the first bottom electrode layer is deposited in such a manner that the first bottom electrode layer covers the first crystal orientation seed layer; and
in the etching the conductive through hole penetrating through the substrate, the conductive through hole passes through the first crystal orientation seed layer.

19. The method according to claim 17, further comprising:
forming a pillar structure on the upper side of the substrate,
wherein in the forming the patterned sacrificial layer on the first bottom electrode layer, a height of the pillar structure is not greater than a thickness of the sacrificial layer.

20. The method according to any one of claims 17 to 19, wherein before the forming the patterned sacrificial layer on the first bottom electrode layer, the method further comprises providing and patterning a barrier layer on the first bottom electrode layer, and the forming the patterned sacrificial layer on the first bottom electrode layer comprises forming the patterned sacrificial layer on the barrier layer; and/or
before the depositing the second bottom electrode layer, the method further comprises providing and patterning a gap seed layer on the sacrificial layer, and the depositing the second bottom electrode layer comprises depositing the second bottom electrode layer on the gap seed layer.

21. An electronic device, comprising the filter according to claim 15 or 16, the resonator according to any one of claims 1 to 14, or a resonator manufactured by the method according to any one of claims 17 to 20.
